(19) **Europäisches Patentamt / European Patent Office / Office européen des brevets**

(11) **EP 4 741 926 A1**

(12) # EUROPEAN PATENT APPLICATION

(43) Date of publication:
**13.05.2026 Bulletin 2026/20**

(21) Application number: **24211443.7**

(22) Date of filing: **07.11.2024**

(51) International Patent Classification (IPC):
**G03F 7/20** (2006.01)

(52) Cooperative Patent Classification (CPC):
**G03F 7/705; G03F 7/70616; G03F 7/70681; G03F 7/706835**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ASML Netherlands B.V.**
**5500 AH Veldhoven (NL)**

(72) Inventor: **URBANCZYK, Adam, Jan**
**5500 AH Veldhoven (NL)**

(74) Representative: **ASML Netherlands B.V.**
**Corporate Intellectual Property**
**P.O. Box 324**
**5500 AH Veldhoven (NL)**

(54) **METHOD OF DETERMINING A PERFORMANCE PARAMETER DISTRIBUTION**

(57)    Provided is a method of determining a performance parameter comprising determining a plurality of regions on a substrate; determining a plurality of performance parameter estimation models corresponding to the plurality of regions; determining performance parameter estimation model parameters for the plurality of performance parameter estimation models and applying at least one of the plurality of performance parameter estimation models with the determined model parameters to determine the performance parameter for the corresponding region of the plurality of regions.

Fig. 3

**Description**

BACKGROUND

Field of the Invention

0001 The present invention relates to a metrology apparatus and methods usable, for example, to perform metrology in the manufacture of devices by lithographic techniques. The invention further relates to such methods for determining a performance parameter in a lithographic process.

Background Art

0002 A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned.

0003 In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a diffraction "spectrum" from which a property of interest of the target can be determined.

0004 Examples of known scatterometers include angle-resolved scatterometers of the type described in US2006033921A1 and US2010201963A1. The targets used by such scatterometers are relatively large, e.g., 40μm by 40μm, gratings and the measurement beam generates a spot that is smaller than the grating (i.e., the grating is underfilled). Examples of dark field imaging metrology can be found in international patent applications US20100328655A1 and US2011069292A1 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

0005 Today's patterning performance may be characterized by edge placement errors (EPE). The position error of the edge of a feature is determined by the features lateral position error (overlay, pattern shift) and the error in size of the feature (CD error). Part of the feature dimension and position errors is very local and stochastic in nature; e.g., dependent on local placement errors relating to local overlay (LOVL), local CD uniformity (LCDU), Line Edge Roughness (LER) and line width roughness (LWR). All of these may be important contributors to the EPE performance.

0006 Owing to the local and stochastic nature of the EPE metric, measuring EPE is metrology intensive, in particular across a substrate. Thus, modelling is typically used to determine EPE distribution. Currently, only a single distribution model is used to describe EPE distribution across a substrate. It may be desirable to provide improved methods of determining performance parameter distribution across a substrate, e.g., EPE.

SUMMARY OF THE INVENTION

0007 The invention in a first aspect provides a method of determining a performance parameter comprising determining a plurality of regions on a substrate; determining a plurality of performance parameter estimation models corresponding to the plurality of regions; determining performance parameter estimation model parameters for the plurality of performance parameter estimation models and applying at least one of the plurality of performance parameter estimation models with the determined model parameters to determine the performance parameter for the corresponding region of the plurality of regions.

0008 In a further embodiments, the invention provides a computer implemented invention comprising the features of the method of the first aspect of the invention. Additionally, the invention provides a computer program comprising program instructions operable to perform the method of the first aspect of the invention, when run on a suitable apparatus, wherein the apparatus may be a lithography apparatus and or a metrology apparatus. The metrology apparatus may be configured to measure metrology data such as alignment data or overlay data. The metrology apparatus may be an external metrology tool located outside the lithography apparatus or an inline metrology tool located inside the lithography apparatus.

0009 Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

BRIEF DESCRIPTION OF THE DRAWINGS

0010 Embodiments of the invention will now be described, by way of example only, with reference to the accompanying schematic drawings in which corresponding reference symbols indicate corresponding parts, and in which:

Figure 1 depicts a lithographic apparatus;
Figure 2 depicts a lithographic cell or cluster in which an inspection apparatus according to the present invention may be used;
Figure 3 depicts an exemplary substrate in accordance with some embodiments;
Figure 4 depicts a method of determining a performance parameter in accordance with some embodiments;
Figure 5 depicts processing steps for applying spatial filtering to a substrate in accordance with some embodiments; and
Figure 6 depicts an exemplary substrate in accordance with some embodiments.

DETAILED DESCRIPTION OF EXEMPLARY EMBODIMENTS

0011 Before describing embodiments of the invention in detail, it is instructive to present an example environment in which embodiments of the present invention may be implemented.

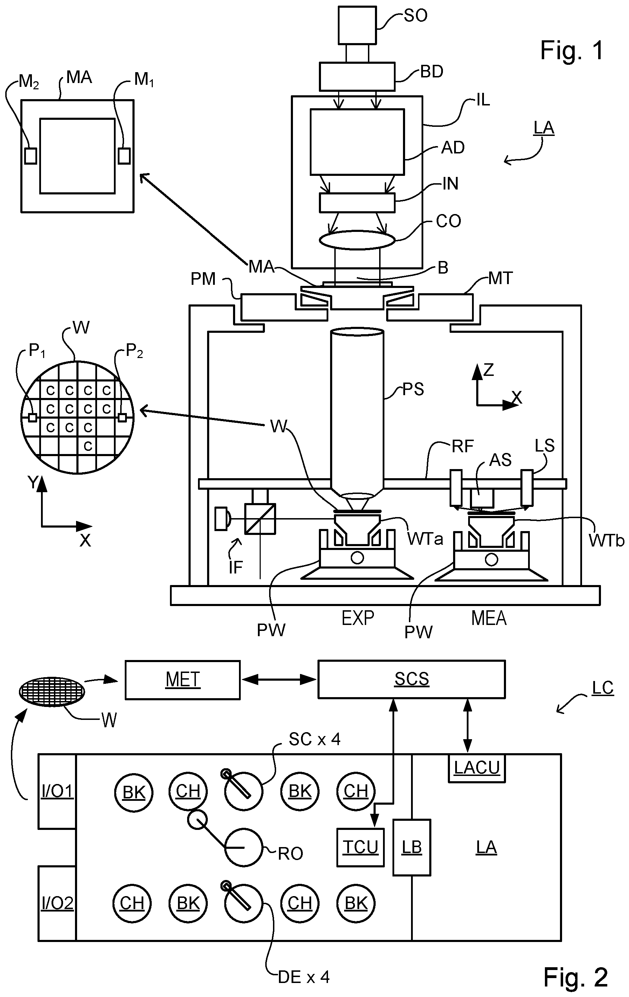

0012 Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

0013 The illumination system may include various types of optical components, such as refractive, reflective, magnetic, electromagnetic, electrostatic or other types of optical components, or any combination thereof, for directing, shaping, or controlling radiation.

0014 The patterning device support holds the patterning device in a manner that depends on the orientation of the patterning device, the design of the lithographic apparatus, and other conditions, such as for example whether or not the patterning device is held in a vacuum environment. The patterning device support can take many forms; the patterning device support may ensure that the patterning device is at a desired position, for example with respect to the projection system.

0015 The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

0016 As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

0017 The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

0018 The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

0019 In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

0020 The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

0021 The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., reticle/mask) MA with respect to the path of the radiation beam B, e.g., after mechanical retrieval from a mask library, or during a scan.

0022 Patterning device (e.g., reticle/mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment mark may also be included within dies, in amongst the device features, in which case it is desirable that the markers be as small as possible and not require any different imaging or process conditions than adjacent features. The alignment system, which detects the alignment markers is described further below.

0023 The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

0024 Combinations and/or variations on the above described modes of use or entirely different modes of use may also be employed.

0025 Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

0026 As shown in Figure 2, the lithographic apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

0027 In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates, especially if the inspection can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

0028 Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it is desirable that the inspection apparatus measure properties in the exposed resist layer immediately after the exposure. However, the latent image in the resist has a very low contrast - there is only a very small difference in refractive index between the parts of the resist which have been exposed to radiation and those which have not - and not all inspection apparatus have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of faulty substrates but may still provide useful information.

0029 Position errors may occur due to an overlay error (often referred to as "overlay"). The overlay is the error in placing a first feature during a first exposure relative to a second feature during a second exposure. The lithographic apparatus minimizes the overlay errors by aligning each substrate accurately to a reference prior to patterning. This is done by measuring positions of alignment marks on the substrate using an alignment sensor. More information on the alignment procedure can be found in U.S. Patent Application Publication No. US 2010-0214550, which is incorporated herein in its entirety by reference. Pattern dimensioning (e.g., CD) errors may, for example, occur when the substrate is not positioned correctly with respect to a focal plane of the lithographic apparatus. These focal position errors may be associated with un-flatness of a substrate surface. The lithographic apparatus aims to minimize these focal position errors by measuring the substrate surface topography prior to patterning using a level sensor. Substrate height corrections are applied during subsequent patterning to help assure correct imaging (focusing) of the patterning device onto the substrate. More information on the level sensor system can be found in U.S. Patent Application Publication No. US 2007-0085991, which is incorporated herein in its entirety by reference.

0030 Besides the lithographic apparatus LA and the metrology apparatus MT, one or more other processing apparatuses may be used during device production as well. An etching station (not shown) processes the substrates after exposure of the pattern into the resist. The etch station transfers the pattern from the resist into one or more layers underlying the resist layer. Typically etching is based on application of a plasma medium. One or more local etching characteristics may e.g. be controlled using temperature control of the substrate or directing the plasma medium using a voltage controlled ring. More information on etching control can be found in PCT Patent Application Publication No. WO 2011-081645 and U.S. Patent Application Publication No. US 2006-016561, which are incorporated herein in their entireties by reference.

0031 During the manufacturing of devices, it is desired that the process conditions for processing substrates using one or more processing apparatuses such as the lithographic apparatus or etching station remain stable such that properties of the features remain within certain control limits. Stability of the process is of particular significance for features of the functional parts of an electric device such as an IC, also referred to as product features. To help ensure stable processing, process control capabilities should be in place. Process control involves monitoring of processing data and implementation of means for process correction, e.g. control a processing apparatus based on one or more characteristics of the processing data. Process control may be based on periodic measurement by the metrology apparatus MT, often referred to as "Advanced Process Control" (further also referenced to as APC). More information on APC can be found in U.S. Patent Application Publication No. US 2012-008127, which is incorporated herein in its entirety by reference. A typical APC implementation involves periodic measurements on metrology features on the substrates to monitor and correct drifts associated with one or more processing apparatuses.

0032 Edge placement error EPE is a composed metric comprising contributions associated with overlay and local placement errors from product structures across multiple layers. To measure the local placement errors, metrology may be performed directly on the product structure. This can be done using a scanning electron microscope (SEM) such as an e-beam metrology apparatus for example. To obtain a dense EPE fingerprint across wafer, a very large metrology effort is required, comprising measurement of many feature instances at many locations on the wafer. More specifically, local effects are typically related to stochastic effects and hence require massive metrology to characterize the stochastic variation via e.g., a histogram. Global contributors (CDU / overlay) are more related to more systematic effects as they relate to, for example, to processing tool fingerprints which are not stochastic in nature.

0033 It is known to model a performance parameter such as EPE based on metrology data. Currently, a single model type is used across an entire substrate, which can lead to a large metrology effort when modelling the EPE with large precision. Some areas of a substrate (e.g., the substrate edge), may require a more complicated model to accurately model more pronounced process effects associated with that area. The model type (i.e., determined based on the most relatively complex substrate area to be modelled) is then used to model the performance parameter across the entire substrate. This may require more metrology than strictly necessary, because areas of the substrate that do not have such pronounced process effects associated therewith may be modelled with a relatively simpler model.

0034 Accordingly, there is proposed a method of determining a performance parameter, for example edge placement error, overlay and/or critical dimension, using a plurality of performance parameter estimation models across a substrate. In an embodiment, the method is also configured to determine the local statistical distribution of the performance parameter. Said plurality of performance parameter estimation models may be from a family of models that are progressively more complicated. A performance parameter estimation model may be determined for a particular location on the substrate based on measurement data (e.g., as obtained by a metrology tool or an alignment sensor) associated with that location and/or based on a previous processing step (or measurement data associated therewith). Where a higher degree of process variation is expected and/or measured, a more complicated model may be used.

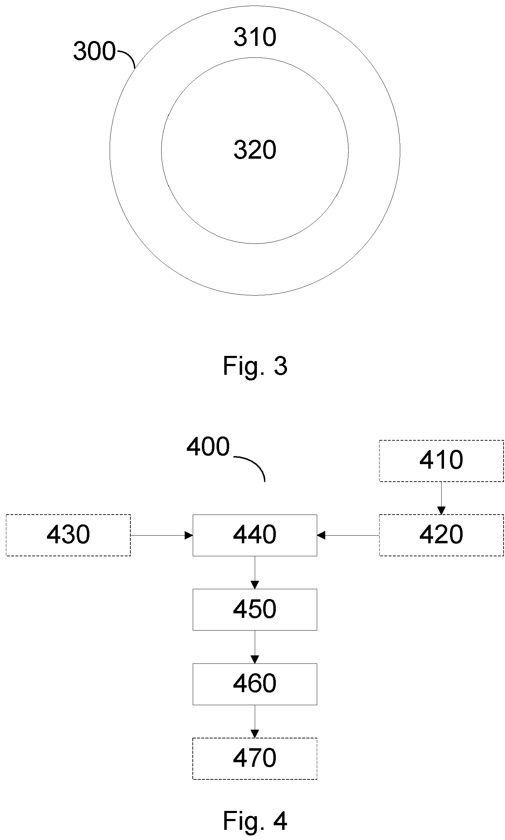

0035 With refence to Figure 3, a purely exemplary substrate 300 may comprise a plurality of regions, or locations, e.g., first region 310 and second region 320. Said first and second regions 310, 320, may be associated with a degree of process variation related to that region. For example, measurement data related to first region 310 may indicated a strong asymmetry in the distribution of a measured feature (i.e. non-zero skewness ), and measurement data related to second region 320 may indicate no asymmetry in the distribution of a measured feature (i.e., zero skewness). Said distribution may describe a variation of said measured feature over a range of values, for example EPE distribution or any other performance parameter distribution such as a CD distribution, feature placement distribution, overlay margin distribution, overlay distribution. Accordingly, parameters of a performance parameter estimation model may be chosen for each of first and second region 310, 320, appropriately. That is, the performance parameter estimation model corresponding to region 310 may include a parameter associated with skewness, whereas the model corresponding to region 320 does not need to include a skewness parameter. By using performance parameter estimation models having varying parameters corresponding to location constraints imposed by a plurality of regions on a substrate (e.g., first and second regions 310, 320) it is possible to increase throughput in contrast to methods that apply a single model to all areas on a substrate indiscriminately, e.g., by configuring a metrology tool according to different models corresponding to each region. By virtue of the proposed method, a reduced measurement time of up to a factor of 2.5 may be realized.

0036 Location constraints may relate to variations of, for example, local overlay, critical dimension and/or other process parameters on a substrate that affect features corresponding to that location (and thus metrology and modelling overhead associated with that location). For example, a substrate that is not substantially flat may have local variations in overlay across the substrate (e.g., having a larger overlay error towards an edge of the substrate). In other examples, said local variation may be caused by a previous processing step, for example variation resulting from an etching step. In yet another example, said variation may be related to feature size, for example a first region on a substrate having relatively smaller features compared to a second region on the substrate, which may result in a relatively larger metrology and/or modelling overhead associated with that region.

0037 With reference to Figure 4, in accordance with a first aspect of the present disclosure, there is provided a method 400 of determining a performance parameter.

0038 In some examples, said method may comprise obtaining 410 measurement data for a plurality of measurement locations on a substrate. That is, for a plurality of measurement locations on a substrate, measurement data may be determined for example using critical dimension scanning electron microscopy (CD-SEM) or scanning electron microscopy overlay (SEM-OL) measurements and/or the like.

0039 The method may further comprise evaluating 420 a performance parameter estimation model for each one of the plurality of locations based on the measurement data so as to obtain a plurality of performance parameter estimation models. That is, a performance parameter estimation model may be selected based on said model having a sufficient (but not excessive) number of model parameters required to accurately model the obtained measurement data. The sufficient number of model parameters required to accurately model the obtained measurement data may be dependent on location constraints imposed by a location on a substrate that the measurement data was obtained from.

0040 In some examples, the plurality of performance parameter estimation models may be determined based on operator, or user, specified constraints (i.e., the model parameters may be predetermined for locations on a substrate).

0041 In some examples, a model family may be pre-selected, provided that in a given family of distributions, the higher order distributions in the family can be reduced to lower order distributions by setting some of the model parameters to a neutral value. Examples of model parameters may comprise location $\mu$, scale $\sigma$, skew $\varepsilon$ and/or kurtosis $\delta$. Some exemplary model families that exhibit such behavior are shown below, and may include normal, split normal, split generalized normal distribution model (Equations 1-3):

$$PDF(x, \mu, \sigma) \sim \qquad \Phi\left(\frac{x-\mu}{\sigma}\right) \qquad (1)$$

$$PDF(x, \mu, \sigma, \varepsilon) \sim \qquad \begin{cases} \Phi\left(\frac{x-\mu}{\sigma(1+\epsilon)}\right) & if\ x \leq \mu \\ \Phi\left(\frac{x-\mu}{\sigma(-+\epsilon)}\right) & if\ x > \mu \end{cases} \qquad (2)$$

$$PDF(x, \mu, \sigma, \varepsilon, \delta) \sim \qquad \begin{cases} \Phi^{1+\delta}\left(\frac{x-\mu}{\sigma(1+\epsilon)}\right) & if\ x \leq \mu \\ \Phi^{1+\delta}\left(\frac{x-\mu}{\sigma(-+\epsilon)}\right) & if\ x > \mu \end{cases} \qquad (3)$$

0042 and/or a normal, sinh-arcsinh distribution model (Equations 4-6):

$$PDF(x, \mu, \sigma) \sim \qquad \Phi\left(\frac{x-\mu}{\sigma}\right) \qquad (4)$$

$$PDF(x, \mu, \sigma, \varepsilon, \delta = 0) \sim \qquad \sinh\left(\sinh^{-1}\left(\Phi\left(\frac{x-\mu}{\sigma}\right)\right) - \epsilon\right) \qquad (5)$$

$$PDF(x, \mu, \sigma, \varepsilon, \delta) \sim \qquad \sinh\left((1+\delta)\sinh^{-1}\left(\Phi\left(\frac{x-\mu}{\sigma}\right)\right) - \epsilon\right) \qquad (6)$$

wherein, $\Phi$ is the standard normal distribution probability density function.

0043 In some examples, basis functions such as b-splines, radial b-splines, and/or radial basis functions (RBFs) may be suitable, provided that said basis functions are compactly supported, i.e., such that location (i.e., regions on a substrate) where certain parameters (e.g., skewness) are neutral may be specified.

0044 In some examples, the method may further comprise determining 440 a plurality of regions (e.g., first and second regions 310, 320) on the substrate.

0045 In some examples, the plurality of regions may be determined based on the plurality of performance parameter estimation models across the substrate. That is, the plurality of regions may be determined or defined based on the number of model parameters comprised in each performance parameter estimation model corresponding to measurement locations comprised in said plurality of regions.

0046 In some examples, the plurality of regions and the corresponding plurality of performance parameter estimation models are determined based on a parameter describing a property of each region of the plurality of regions. Said property may be any of location, scale, skewness and/or kurtosis of measurement data corresponding to each region or the plurality of regions.

0047 In some examples, the method may comprise, at step 430, pre-determining said plurality of regions (and thus model orders corresponding to said regions) based on a previous processing step, e.g., when a user or operator has a *priori* knowledge of regions on a substrate that may require a higher or lower order model. In such a case, a performance parameter estimation model may be manually assigned to the plurality of regions on a substrate based on said a-priori knowledge.

0048 The method further comprises, at step 450, determining performance parameter estimation model parameters for the plurality of performance parameter estimation models. That is, model parameters such as location $\mu$, scale $\sigma$, skew $\varepsilon$ and/or kurtosis $\delta$ may be determined for each of the plurality of performance parameter estimation models. For example, a location on a substrate may require more or less model parameters owing to more pronounced processing effects (i.e., location constraints) associated with that location (e.g., towards a substrate edge). This may be achieved by constructing hyperparameter models for each model parameter only in locations where that model parameter is supported, and hyperparameter fitting each of the model parameters in accordance with each performance parameter estimation model.

0049 In some examples, a particular family of models may be evaluated for each measurement location (i.e., a location on the substrate where measurement data was obtained) in order to determine which model in the family of models most accurately models the obtained measurement data based on an evaluation criterion. Such an evaluation criterion may comprise, for example, determining an estimation accuracy metric. This may be achieved, for example, by using the Akaike information criterion (AIC). The Akaike information criterion is an estimator of estimation error and thereby relative quality of statistical models for a given set of data. Given a collection of models for the data, the AIC may estimate the quality of each model, relative to each of the other models. Thus, AIC may provide a means for model selection. Of course, the AIC is only an example of an estimation accuracy metric and any suitable metric for quantifying and/or assessing estimation accuracy and/or error may be used.

0050 The method further comprises applying 460 at least one of the plurality of performance parameter estimation models with the determined model parameters to determine the performance parameter for the corresponding plurality of regions. For example, for each location, an associated performance parameter estimation model may evaluate the desired performance parameter, e.g., edge placement error. In this way, the performance parameter may be determined using a location-specific model, thus improving throughput when compared to evaluating a performance parameter across an entire substrate using a single model.

0051 Locations associated with lower order models may not require the same sampling density per-region as locations associated with higher order models. Thus, metrology speed and/or throughput may be improved by, for example, changing (e.g., reducing) the field of view (FOV) size or sampling scheme used to measure or evaluate locations associated with lower order models. Accordingly, the method may further comprise configuring 470 a property of a measurement apparatus, for example FOV size and/or or sampling scheme based on the determined plurality of regions.

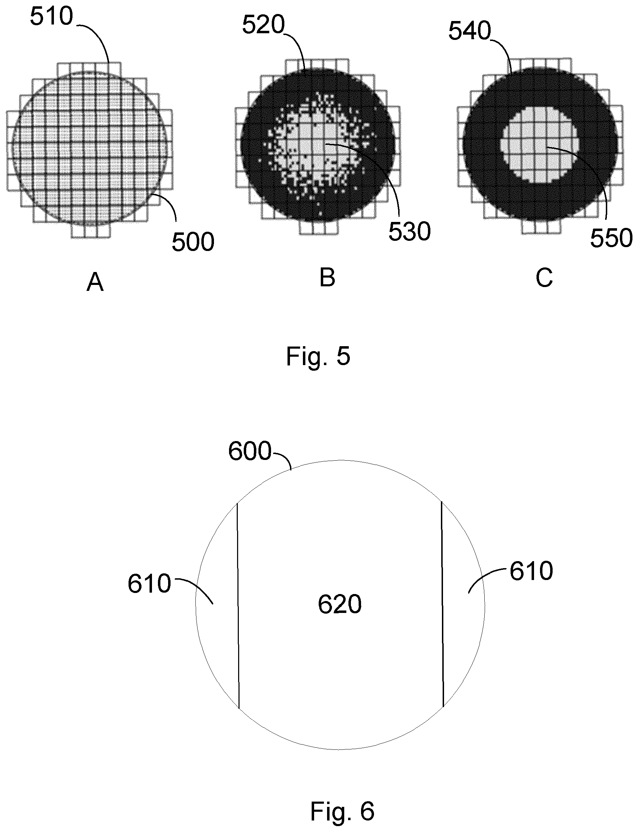

0052 Figure 5 depicts further examples of the method of the present invention. In particular, Figure 5 shows the embodiment wherein the plurality of regions are determined based on obtaining measurement data and selecting a performance parameter estimation model for each one of the plurality of locations based on said measurement data. In addition to this embodiment, Figure 5 further describes embodiments wherein the method of the present invention may further comprise applying spatial filtering to remove noise in the performance parameter estimation models across the substrate.

0053 In particular, Figure 5A depicts a purely exemplary substrate that is subdivided into a plurality of measurement locations for obtaining measurement data (i.e., using a measurement grid 510). Referring to Figure 5B, the black areas 520 on the substrate correspond to a first performance parameter estimation model and the grey areas 530 correspond to a second performance parameter estimation model. As can be seen from Figure 5B, there is no well-defined edge between the black areas 520 and grey areas 530, e.g., owing to noise such as shot noise. In order to provide well defined regions, the method may comprise spatially filtering the determined models, e.g., using moving window max count filtering or any other suitable filtering method, in order to determine the well-defined regions shown in Figure 5C, i.e. first region 540 and second region 550.

0054 Although the plurality of regions are shown in Figure 3 and Figure 5 (i.e., first and second regions 310, 320, or 540, 550, respectively) as concentric with respect to a substrate, these depictions are purely exemplary, and the plurality of regions may be defined as required by any particular use case. Figure 6 shows a further example of how the plurality of regions may be defined and shows a first region 610 defined on opposite edges of substrate 600 and comprising a second region 620 in the centre of the substrate.

0055 The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

0056 The term "lens", where the context allows, may refer to any one or combination of various types of optical components, including refractive, reflective, magnetic, electromagnetic and electrostatic optical components.

0057 The term target should not be construed to mean only dedicated targets formed for the specific purpose of metrology. The term target should be understood to encompass other structures, including product structures, which have properties suitable for metrology applications.

0058 The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

0059 The breadth and scope of the present invention should not be limited by any of the above-described exemplary embodiments, but should be defined only in accordance with the following claims and their equivalents.

0060 The following clauses describe various aspects of the invention.

1. A method of determining a performance parameter, comprising:

determining a plurality of regions on a substrate;
determining a plurality of performance parameter estimation models corresponding to the plurality of regions;
determining performance parameter estimation model parameters for the plurality of performance parameter estimation models; and
applying at least one of the plurality of performance parameter estimation models with the determined model parameters to determine the performance parameter for the corresponding region of the plurality of regions.

2. The method of clause 1, wherein the plurality of regions and corresponding plurality of performance parameter estimation models are determined based on a previous processing step of the substrate.

3. The method of any previous clause, wherein the plurality of regions and the corresponding plurality of performance parameter estimation models are determined based on a parameter describing a property of each region of the plurality of regions.

4. The method of clause 3, wherein the property is location, scale, skewness and/or kurtosis of measurement data corresponding to each region or the plurality of regions.

5. The method of clause 4, wherein the step of determining the plurality of performance parameter estimation models further comprises:

measuring a plurality of measurement locations on the substrate to obtain the measurement data; and
evaluating a performance parameter estimation model for each of the plurality of measurement locations based on the measurement data so as to obtain the plurality of performance parameter estimation models;
wherein the plurality of regions are determined based on the plurality of performance estimation models.

6. The method of any of clause 5, further comprising applying spatial filtering to remove noise in the plurality of performance estimation models across the substrate.

7. The method of any previous clause, wherein the model parameters of the plurality of performance parameter estimation models are determined by hyperparameter fitting for each one of the parameters comprised in each performance parameter estimation model.

8. The method of any previous clause, further comprising configuring a property of a measurement apparatus based on the determined plurality of regions.

9. The method of clause 8, wherein the property of the measurement apparatus is a field of view and/or a sampling scheme.

10. The method of any previous clause, wherein the performance parameter is edge placement error, overlay and/or critical dimension.

11. The method of any previous clause, wherein the method is configured to determine the local statistical distribution of the performance parameter.

12. The method of any previous clause, wherein each of said plurality of performance estimation models comprises a respective distribution model.

13. The method of any previous clause, wherein model parameters comprise one or more of location, scale, skew and/or kurtosis.

14. The method of any previous clause, wherein the plurality of performance estimation models comprise a model family, wherein the higher order distributions in the model family can be reduced to lower order distributions by setting one or more of the model parameters to a neutral value.

15. The method of clause 14 further comprising evaluating the family of models for each of the plurality of locations based on an evaluation criterion.

16. The method of clause 15, wherein said evaluation criterion determines an estimation accuracy metric.

17. The method of clause 15 or 16, wherein the evaluation criterion is an Akaike information criterion.

18. A computer program comprising program instructions operable to perform the method of any preceding clause, when run on a suitable apparatus.

19. A non-transient computer program carrier comprising the computer program of clause 18.

20. A processing arrangement comprising:

the non-transient computer program carrier of clause 19; and

a processor operable to run the computer program comprised on said non-transient computer program carrier.

21. A lithographic apparatus comprising:

an alignment sensor;

a patterning device support for supporting a patterning device;

a substrate support for supporting a substrate; and

the processing arrangement of clause 20.

22. The lithographic apparatus of clause 21, wherein the alignment sensor is operable to measure the substrate to obtain said measurement data.

23. The lithographic apparatus of clause 21 or 22, wherein the processing arrangement is further operable to determine corrections for control of said patterning device and/or substrate support based on the determined performance parameter.

24. A metrology apparatus comprising the processing arrangement of clause 20.

25. The metrology apparatus of clause 24, operable to measure the substrate to obtain said measurement data.

26. The metrology apparatus of clause 24 or 25, wherein the processing arrangement is further operable to determine corrections for controlling a property of said metrology apparatus based on the determined performance parameter.

27. The metrology apparatus of clause 26, wherein the property of the metrology apparatus is a field of view and/or a sampling scheme.


**Claims**

1. A method of determining a performance parameter, comprising:

determining a plurality of regions on a substrate;

determining a plurality of performance parameter estimation models corresponding to the plurality of regions;

determining performance parameter estimation model parameters for the plurality of performance parameter estimation models; and

applying at least one of the plurality of performance parameter estimation models with the determined model parameters to determine the performance parameter for the corresponding region of the plurality of regions.

2. The method of claim 1, wherein the plurality of regions and corresponding plurality of performance parameter estimation models are determined based on a previous processing step of the substrate.

3. The method of any previous claim, wherein the plurality of regions and the corresponding plurality of performance parameter estimation models are determined based on a parameter describing a property of each region of the plurality of regions;

wherein the property is location, scale, skewness and/or kurtosis of measurement data corresponding to each region or the plurality of regions.

4. The method of claim 3, wherein the step of determining the plurality of performance parameter estimation models further comprises:

measuring a plurality of measurement locations on the substrate to obtain the measurement data;

evaluating a performance parameter estimation model for each of the plurality of measurement locations based on the measurement data so as to obtain the plurality of performance parameter estimation models, wherein the plurality of regions are determined based on the plurality of performance estimation models; and

applying spatial filtering to remove noise in the plurality of performance estimation models across the substrate.

5. The method of any previous claim, wherein the model parameters of the plurality of performance parameter estimation models are determined by hyperparameter fitting for each one of the parameters comprised in each performance parameter estimation model.

6. The method of any previous claim, further comprising configuring a property of a measurement apparatus based on the determined plurality of regions, wherein the property of the measurement apparatus is a field of view and/or a sampling scheme.

7. The method of any previous claim, wherein the performance parameter is edge placement error, overlay, critical dimension and/or the local statistical distribution of said performance parameters.

8. The method of any previous claim, wherein each of said plurality of performance estimation models comprises a respective distribution model.

9. The method of any previous claim, wherein model parameters comprise one or more of location, scale, skew and/or kurtosis.

10. The method of any previous claim, wherein the plurality of performance estimation models comprise a model family, wherein the higher order distributions in the model family can be reduced to lower order distributions by setting one or more of the model parameters to a neutral value; and
wherein the method further comprises evaluating the family of models for each of the plurality of locations based on an evaluation criterion, wherein said evaluation criterion determines an estimation accuracy metric.

11. A non-transient computer program carrier comprising program instructions operable to perform the method of any preceding claim, when run on a suitable apparatus.

12. A processing arrangement comprising:

the non-transient computer program carrier of claim 11; and
a processor operable to run the computer program comprised on said non-transient computer program carrier.

13. A metrology apparatus comprising the processing arrangement of claim 12.

14. The metrology apparatus of claim 13, operable to measure the substrate to obtain said measurement data.

15. The metrology apparatus of claim 13 or 14, wherein the processing arrangement is further operable to determine corrections for controlling a property of said metrology apparatus based on the determined performance parameter, wherein the property of the metrology apparatus is a field of view and/or a sampling scheme.

Fig. 1

Fig. 2

300 310

320

Fig. 3

400

410

430 → 440 ← 420

450

460

470

Fig. 4

510

520

540

530

500

550

A

B

C

Fig. 5

600

610

620

610

Fig. 6

Europäisches
Patentamt

European
Patent Office

Office européen
des brevets

# EUROPEAN SEARCH REPORT

**Application Number**

EP 24 21 1443

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2023/198381 A1 (ASML NETHERLANDS BV [NL]) 19 October 2023 (2023-10-19) | 1-3,6-9, 11-15 | INV. G03F7/20 |
| Y | * paragraphs [0002], [0043] - [0068], | 4,5 | |
| A | [0085]; figure 5 * | 10 | |
| | ----- | | |
| Y | WO 2019/145092 A1 (ASML NETHERLANDS BV [NL]) 1 August 2019 (2019-08-01) * paragraph [0236] * | 4 | |
| | ----- | | |
| Y | US 2017/160074 A1 (MOSSAVAT SEYED IMAN [NL] ET AL) 8 June 2017 (2017-06-08) * paragraph [0008] * | 5 | |
| | ----- | | |

**TECHNICAL FIELDS SEARCHED (IPC)**

G03F

The present search report has been drawn up for all claims

| Place of search | Date of completion of the search | Examiner |
|---|---|---|
| Munich | 28 April 2025 | Eisner, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 21 1443

This annex lists the patent family members relating to the patent documents cited in the above-mentioned European search report.
The members are as contained in the European Patent Office EDP file on
The European Patent Office is in no way liable for these particulars which are merely given for the purpose of information.

28-04-2025

| Patent document cited in search report | | | Publication date | Patent family member(s) | | Publication date |
|---|---|---|---|---|---|---|
| WO 2023198381 | A1 | | 19-10-2023 | CN | 119013622 A | 22-11-2024 |
| | | | | KR | 20250005112 A | 09-01-2025 |
| | | | | TW | 202405585 A | 01-02-2024 |
| | | | | WO | 2023198381 A1 | 19-10-2023 |
| WO 2019145092 | A1 | | 01-08-2019 | CN | 111670411 A | 15-09-2020 |
| | | | | CN | 117590701 A | 23-02-2024 |
| | | | | EP | 3743771 A1 | 02-12-2020 |
| | | | | KR | 20200100166 A | 25-08-2020 |
| | | | | KR | 20220140657 A | 18-10-2022 |
| | | | | KR | 20230140608 A | 06-10-2023 |
| | | | | TW | 201940985 A | 16-10-2019 |
| | | | | TW | 202107226 A | 16-02-2021 |
| | | | | TW | 202136931 A | 01-10-2021 |
| | | | | US | 2020371441 A1 | 26-11-2020 |
| | | | | US | 2023221654 A1 | 13-07-2023 |
| | | | | US | 2024377756 A1 | 14-11-2024 |
| | | | | WO | 2019145092 A1 | 01-08-2019 |
| US 2017160074 | A1 | | 08-06-2017 | CN | 108369381 A | 03-08-2018 |
| | | | | IL | 259291 A | 31-07-2018 |
| | | | | JP | 6697551 B2 | 20-05-2020 |
| | | | | JP | 2019504293 A | 14-02-2019 |
| | | | | KR | 20180088729 A | 06-08-2018 |
| | | | | NL | 2017789 A | 13-06-2017 |
| | | | | TW | 201730513 A | 01-09-2017 |
| | | | | US | 2017160074 A1 | 08-06-2017 |
| | | | | WO | 2017093011 A1 | 08-06-2017 |

EPO FORM P0459

For more details about this annex : see Official Journal of the European Patent Office, No. 12/82

**EP 4 741 926 A1**

**Patent documents cited in the description**

- US 2006033921 A1
- US 2010201963 A1
- US 20100328655 A1
- US 2011069292 A1
- US 20110027704 A
- US 20110043791 A
- US 2011102753 A1
- US 20120044470 A
- US 20120123581 A
- US 20130258310 A
- US 20130271740 A
- WO 2013178422 A1
- US 20100214550 A
- US 20070085991 A
- WO 2011081645 A
- US 2006016561 A
- US 2012008127 A